# EUROPEAN PATENT APPLICATION

(11) **EP 4 266 583 A1**
(43) Date of publication of application: **25.10.2023**
(21) Application number: 22211036.3
(22) Date of filing: 02.12.2022
(51) Int. Cl.: H03L 7/093, H03L 7/107

(54) **PHASE LOCKED LOOP CIRCUIT, ELECTRONIC CIRCUIT ARRANGEMENT AND ELECTRONIC APPARATUS**

(30) Priority: 22.04.2022 CN 202210431138
(71) Applicant: Rohde & Schwarz GmbH & Co. KG, 81671 München (DE)
(72) Inventor: SEEGER, Julius, 83209 Prien am Chiemsee (DE); HELD, Werner, 94060 Pocking (DE)
(74) Representative: Isarpatent

(57) **Abstract**

The present invention relates to a phase-locked loop (PLL) circuit which comprises a variable frequency oscillator, loop filter having a first fine filter path and a second coarse filter path and a boost circuit. According to the invention, the boost circuit is configured to provide at least one additional boost voltage signal to the output signal of the second filter path as a predetermined control signal activates the boost circuit. The invention further relates to an electronic circuit arrangement comprising such a phase locked loop circuit and an electronic apparatus.

## Description

### FIELD OF THE INVENTION

The present invention relates to a phase locked loop circuit. The invention further relates to an electronic circuit arrangement comprising such a phase locked loop circuit and an electronic apparatus.

### TECHNICAL BACKGROUND

Phase-locked loop (PLL) circuits - hereinafter also referred to as PLLs - are used in a wide variety of applications requiring an output signal with a phase/frequency locked to the phase/frequency of an input signal. PLLs can be used in clocking systems, for instance. A commonly known PLL circuit such as disclosed in US 8,274,317 B1 includes a phase frequency detector (PFD), a charge pump, a loop filter, a voltage-controlled oscillator (VCO) and a feedback or control loop with a divider.

The control loop compares the phase/frequency of the output signal received from the VCO to the phase/frequency of the input signal. A control signal (typically a voltage) is generated based on this comparison and is used to adjust the frequency of the VCO until the loop matches the reference signal. The output signal frequency can be a multiple of the input signal frequency. The control signal can be differential or single-ended depending on the application. Modern PLLs are typically embodied in the form of a semiconductor integrated circuit (IC) as part of an electronic chip, such as memory devices, frequency synthesis circuits, or clock recovery circuits of data processing circuits. Often the output of a PLL is triggering an analogue to digital converter (DAC).

PLLs may also be used for high frequency applications. Such a PLL is for example implemented in the AD9173 of Analog Devices, Inc. which refers to a 16 bit, radio frequency (RF) DAC. The circuit design of the PLL used in the AD9173 DAC is for example shown in Fig. 90 and described on page 64 of the data sheet for the AD9173 DAC.

The VCO of the PLL of the AD9173 DAC is triggered by means of a two stage loop filter. This loop filter of the AD9173 DAC comprises a standard passive loop filter path FILT_FINE with rather high bandwidth. However, as the tuning range of the PLL input is restricted to roughly 0,2% of the reference frequency, an additional filter path FILT_COARSE is provided. The bandwidth of this simultaneously operating additional loop filter path FILT_COARSE is much slower than the one of the fine filter path FILT_FINE in order to maintain stability of the PLL.

To avoid spurs in the direct digital synthesizer (DDS) output of the DAC, the reference frequency has to be shifted and the PLL has to settle very fast. Otherwise, the setting time will increase. With the circuit design used in the PLL of the AD9173 DAC of Analog Devices, comparably high settling times in the order of one millisecond are realized. In order to decrease these settling times the PLL bandwidth needs to be increased by increasing the loop bandwidth of both loop filter paths which, however, goes to the expense of an undesirably high phase noise as the phase noise will also be increased by this measure.

Another problematic issue with the AD9173 circuit design of Analog Devices is the limited performance of the PLL circuit. This plays a role especially for such applications where the frequency of the input clock signal is changing very fast which results in an increasing difference between the two frequencies of the input signal and the feedback signal. While small clock fluctuations are compensated directly by the fine filter path FILT_FINE which reacts rather fast, for greater clock fluctuations the additional filter path FILT_COARSE is used which however may not follow the dynamics of the clock changes. Presently, there is no solution for this drawback. Using this kind of PLL circuit for a DAC in a vector network analyser, measurement sweeps would take too long.

This is a situation that needs to be improved.

### SUMMARY OF THE INVENTION

Against this background, the problem addressed by the present invention is that of providing an enhanced PLL circuit exhibiting better performances in particular when operated within a wide frequency range. Further, it is desirable to provide an optimized PLL circuit with decreased settling times while maintaining small loop bandwidths for reduced phase noise.

At least one of these problems is solved according to the invention by a PLL circuit, by an electronic circuit arrangement comprising such a phase locked loop circuit and/or by an electronic apparatus having the features of the independent claims.

Accordingly, the following is provided:
- A phase-locked loop (PLL) circuit, the PLL circuit comprising: a variable frequency oscillator comprising at least one first and at least one second input terminal, a loop filter configured to control operation of the variable frequency oscillator, wherein the loop filter comprises a first filter path connected to the first input terminal of the variable frequency oscillator and a second filter path connected to the second input terminal of the variable frequency oscillator, wherein the first filter path has a higher bandwidth and a smaller tuning range than the second filter path, a controllable boost circuit coupled to or part of the second filter path and comprising a control terminal, wherein the boost circuit is configured to provide at least one additional voltage signal to the second input terminal in case the control terminal receives a predetermined control signal.
- An electronic circuit arrangement, comprising: a PLL circuit according to the invention; a direct digital synthesizer (DDS) circuit connected to an output of the PLL circuit or the variable frequency oscillator.
- An electronic device, comprising the electronic circuit arrangement according to the invention.

The present invention is based on the concept of providing an additional boost circuit which may be switched to the second filter path of the loop filter, if required. This boost circuit is configured to add an additional voltage or boost signal to the output of the second filter path which is fed to the VCO. The additional voltage preferably matches a necessary voltage jump induced by a change in an error signal generated from a phase and frequency detector (PFD). Using an additional boost circuit for the second filter path enables using the original, slow loop filter path while maintaining low phase noise and decreasing settling times.

The solution according to the present invention is especially suited as a supplement of the AD917x family of RF-DACs from Analog Devices. The PLL circuits according to the present invention are robust against temperature changes, are comparably economic due to less manufacturing costs, need reduced PCB space. Further, the PLL exhibit low power consumption and offers comparably decreased phase noise.

Advantageous configurations and developments emerge from the further dependent claims and from the description with reference to the figures of the drawings.

In a preferred embodiment, the PLL circuit further comprises an error detection circuit. The error detection circuit is connected on the control side to the boost circuit and is configured to detect an error condition of the PLL. According to the invention, the error detection circuit is configured to provide the predetermined control signal to the control terminal of the boost circuit in case an error condition of the PLL is detected. An error condition may be a predetermined variation or change of the external reference frequency of the input signal, a predetermined variation or change of the settings of the divider of the PLL circuit, exceeding a predetermined settling time, or the like.

In a further preferred configuration, the variable frequency oscillator is a voltage controlled oscillator (VCO). A VCO is an analogue electronic oscillator whose oscillation frequency is controlled by a voltage input. The applied input voltage determines the instantaneous oscillation frequency.

In a preferred embodiment, the boost circuit is an integral part of the circuitry of the loop filter and in particular of its second filter path. However, it would also be possible to provide an external boost circuit separate to the loop filter or the second filter path.

In a further embodiment, the loop filter is an external filter circuit separate from the integrated circuit elements of the remaining PLL circuit. In particular, the loop filter is not mounted within the integrated circuit carrying the VCO.

In a particularly preferred embodiment, the first filter path is faster than the second filter path. In particular, the first filter path is faster than the second filter path such that the first filter path is configured to provide a fine frequency calibration setting signal to the first input terminal and that the second filter path is configured to provide a comparably course frequency calibration setting signal to the second input terminal. Consequently, the first filter path which is a fine filter offers a quick and fine triggering signal for the variable frequency oscillator, however, can compensate only for smaller errors than the second filter path which is a coarse filter. The error could be a frequency difference detected by the phase frequency detector (PFD) which is fed to the variable frequency oscillator.

According to a typical configuration, the boost circuit comprises a switching circuit. The switching circuit is configured to switch the loop filter and in particular its second filter path between a normal operating mode and at least one boost operating mode. In the normal operating mode the loop filter and its second filter path are operated without the boost circuit which is switched off in this mode. For the boost operating mode, at least one boost circuit is activated and the boost voltages produced by the activated boost circuit is then added to the output voltage of the second filter path. Preferably, the switching circuit comprises a single pole, double throw (SPDT) switch. Using this kind of switch offers a low switching time, which typically is in the order of several 10 nsec and can therefore be neglected. However, also other switches, such as semiconductor switches like a MOSFET may be used.

According to a further configuration, the boost circuit comprises at least one voltage source. The voltage source is preferably connected between the switching circuit and a positive or a negative DC reference voltage. In case that the boost circuit is activated for example via the switching circuit, the voltage source is configured to provide the additional voltage signal or boost voltage to the second filter path and/or to the second input terminal.

According to preferred embodiments, the voltage sources for the boost circuit is realised by a voltage divider, an operational amplifier, a DAC and/or a reference diode.

In a particular preferred embodiment, the boost circuit comprises at least two different boost paths. Each of these different boost paths provides a different additional voltage signal to the second input terminal of the VCO. In this way, it is possible to effectively compensate for different frequency changes. Preferably, a first additional voltage signal is a positive voltage and a second additional voltage signal is a negative voltage. In other embodiments, it is also preferable that the different additional voltage signals provided by the different boost paths have different voltage levels.

In a further preferred configuration, the second filter path comprises at least one first capacitor arranged between the switching circuit and the second input terminal. This first capacitor provides the coarse filtering of the loop filter which is configured to provide the full tuning capability.

In a preferred embodiment, at least one of the boost paths and/or the second filter path comprises an RC circuit. The resistors and capacitors of at least one of these RC circuits are preferably designed such to be used for temperature compensation and/or temperature stability. In particular, the RC circuit of the second filter path is a passive circuit element where the resistor is grounded.

According to a typical configuration, the variable frequency oscillator comprises a third input terminal. A common tap between the first filter path and the second filter path of the loop filter is directly (i.e. without capacitors or resistor elements) connected to the third input terminal of the variable frequency oscillator.

The PLL circuit according to the present invention further comprises at least one frequency divider and a phase frequency detector (PFD). The frequency divider having a fixed or tunable divider factor is arranged in a feedback loop of the PLL and is configured to divide the phase/frequency of the variable frequency oscillator and to provide a PLL feedback signal. The PFD is configured to detect a phase difference between a reference input signal and the PLL feedback signal provided by the feedback loop and to provide a phase/frequency error signal that corresponds to the detected phase/frequency error. The loop filter is then configured to sequentially process a phase/frequency error signal provided by the PFD or a charge pump and to provide corresponding control signals to the variable frequency oscillator depending on the transfer function of the loop filter.

The PLL circuit preferably, but not compulsory, further comprises a PLL charge pump. The PLL charge pump is arranged between an output terminal of the PFD and the loop filter.

In a typical configuration of the electronic circuit arrangement, the DDS circuit comprises at least one high frequency digital to analogue circuit (DAC). A basic DDS consists of a frequency reference (often a crystal or SAW oscillator), a digital oscillator (such as a NCO) and a DAC. A reference oscillator which may be part of the PLL circuit provides a stable time base for the system and determines the frequency accuracy of the DDS.

In a preferred embodiment, the electronic apparatus comprises at least one of: a network analyzer; a signal analyzer; a spectrum analyzer; a signal generator; a measurement apparatus; signal source.

Where appropriate, the above-mentioned configurations and developments can be combined in any manner. Further possible configurations, developments and implementations of the invention also include combinations, which are not explicitly mentioned, of features of the invention which have been described previously or are described in the following with reference to the embodiments. In particular, in this case, a person skilled in the art will also add individual aspects as improvements or supplements to the basic form of the present invention.

### CONTENT OF THE DRAWINGS

The present invention is described in greater detail in the following on the basis of the embodiments shown in the schematic figures of the drawings, in which:
- Fig. 1: is a block diagram of a first, generic embodiment of a PLL according to the invention;
- Fig. 2: is a block diagram of a second, more specific embodiment of a PLL according to the invention;
- Fig. 3: is a block diagram of a second, more specific embodiment of a PLL according to the invention;
- Fig. 4: shows an example of error generation circuit 70 in more detail;
- Fig. 5: shows a first embodiment of a loop filter and a boost circuit according to the invention;
- Fig. 5A: shows the behaviour of a PLL with the loop filter of Fig. 5 without the additional boost circuit;
- Fig. 5B: shows the behaviour of a PLL with the loop filter of Fig. 5 with the additional boost circuit;
- Fig. 6: shows a second embodiment of the loop filter and a boost circuit according to the invention;
- Fig. 7: shows a third embodiment of the loop filter and a boost circuit according to the invention;
- Fig. 8: shows a forth embodiment of the loop filter and a boost circuit according to the invention;
- Fig. 9: shows a fifth embodiment of the loop filter and a boost circuit according to the invention;
- Fig. 10: shows a sixth embodiment of the loop filter and a boost circuit according to the invention.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

### DESCRIPTION OF EMBODIMENTS

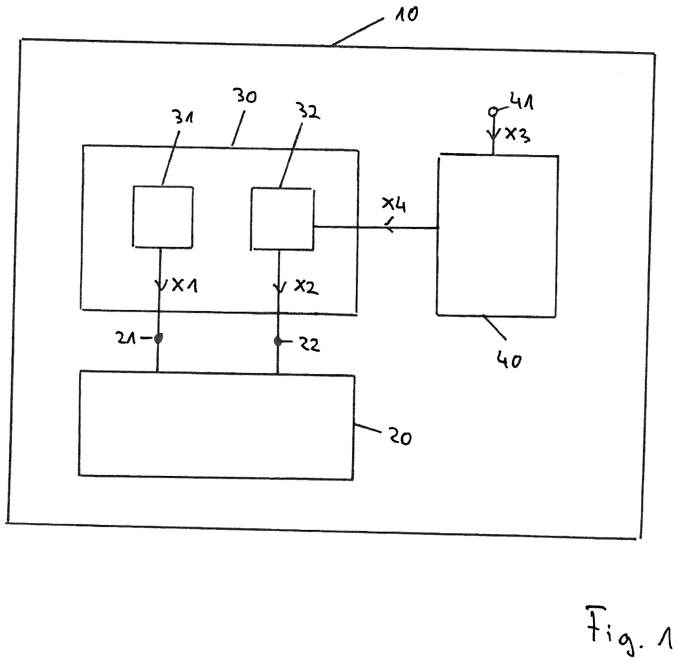

Fig. 1 shows a block diagram of a first, generic embodiment of a phase-locked loop (PLL) circuit according to the invention.

The PLL circuit - or shortly PLL - is denoted by reference symbol 10. The PLL 10 refers to a control system that generates an output signal which is related to the phase/frequency of an input signal. Keeping the output in lock condition also implies keeping the input and output frequencies the same. In addition to synchronizing clock signals, a PLL is able to track an input frequency, or it can generate a frequency that is a multiple of the input frequency. These properties are used for computer clock synchronization, demodulation and frequency synthesis.

The PLL 10 shown in Fig. 1 comprises a variable frequency oscillator 20, a loop filter 30 and a boost circuit 40.

The variable frequency oscillator 20 is an electronic circuit that produces a periodic, oscillating electronic signal. In analog circuits, the variable frequency oscillator 20 is often realized in the form of a voltage controlled oscillator (VCO) 20, so that the oscillation frequency can be varied over some range by an input voltage or current. For digital PLLs, often numerically controlled oscillator (NCO) are used. According to the present invention, the variable frequency oscillator 20 comprises at least one first input terminal 21 and at least one second input terminal 22.

The loop filter 30 which is configured to control operation of the variable frequency oscillator 20 is connected to the input side of the downstream arranged variable frequency oscillator 20. For controlling the variable frequency oscillator 20, the loop filter 30 comprises a first filter path 31 which is connected to the first input terminal 21 of the variable frequency oscillator 20 and a second filter path 32 which is connected to the second input terminal 22 of the variable frequency oscillator 20. The first filter path 31 is configured to provide a first frequency calibration setting signal X1 to the first input terminal 21 and the second filter path 32 is configured to provide a second frequency calibration setting signal X2 to the second input terminal 22. According to the invention, the first filter path 31 has a much higher bandwidth and a smaller tuning range compared to the second filter path 32 such that the filter path 31 is faster and thus more dynamic compared to that of the second filter path 32.

According or the invention, the PLL comprises a boost circuit 40 which comprises a control terminal 41 for receiving a control signal X3. The boost circuit 40 may be coupled to the second filter path 32. Preferably, the boost circuit 40 is part of the second filter path 32 (not shown in Fig. 1). The boost circuit 40 is configured to provide at least one additional voltage signal X4 - also referred to as boost voltage - to the second input terminal 22 of the variable frequency oscillator 20 in case that the control terminal 41 receives a predetermined control signal X3.

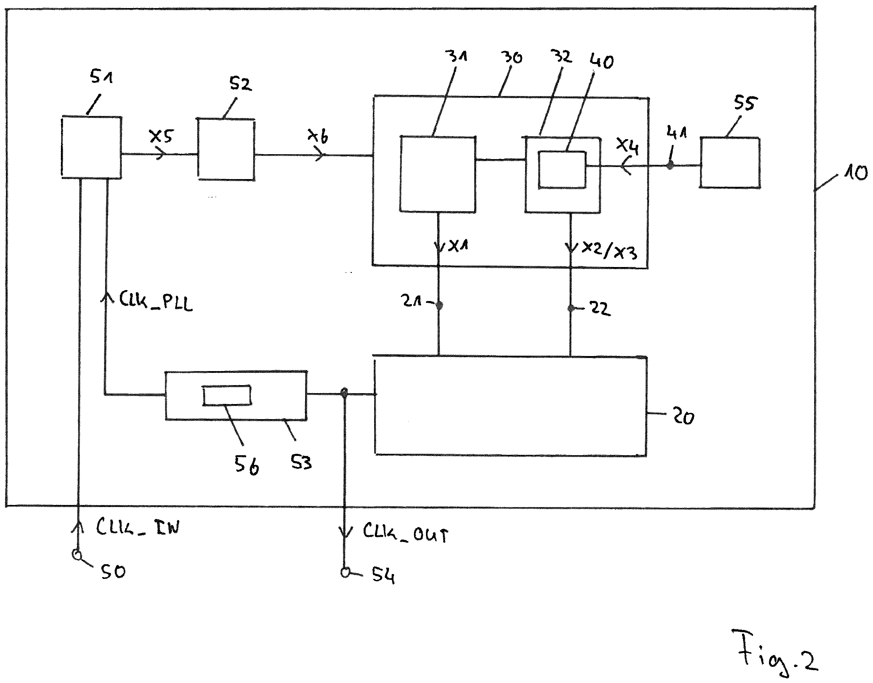

Fig. 2 shows a block diagram of a second, more specific embodiment of a phase-locked loop (PLL) circuit according to the invention.

In the embodiment of Fig. 2, the variable frequency oscillator 20 is a voltage controlled oscillator (VCO) 20. In addition to the PLL 10 shown in Fig. 1, the PLL in Fig. 2 comprises an input terminal 50, a phase detector 51, a PLL charge pump 52, a feedback loop 53, an output terminal 54 and an error detection circuit 55.

The input terminal 50 is configured to receive an input clock signal CLK_IN, such as a reference clock signal CLK_IN. In the present case, the input clock signal CLK_IN is a voltage clock signal.

The phase detector 51 - also called phase comparator - in this embodiment is a phase frequency detector (PFD) 51. The input side of the PFD 51 is connected to the input terminal 50 and the feedback loop 53. The phase detector 51 is configured to detect a phase difference between the input clock signal CLK_IN and a PLL feedback clock signal CLK_PLL (which may be divided by n) at its inputs. The phase detector 51 is configured to provide an error signal X5 that corresponds to the phase/frequency error between these two clock signals CLK_IN, CLK_PLL.

Analogue multipliers may used as phase detectors 51 in analogue PLLs, for example a Gilbert cell, which has an approximately linear transmission behaviour in the range of small error values. Very common, especially in analogue PLLs, are also up-down counters, which not only compare the phase in a highly linear way, but also indicate the slip direction in case the PLL is not yet latched. In digital PLLs 10, exclusive-OR gates or sequential logic circuits in the form of flip-flops are often used as phase detectors 51.

The PLL charge pump 52 is arranged between an output terminal of the PFD 51 and the loop filter 30. The term charge pump is commonly used in PLL circuits even though there is no real pumping action involved. Moreover, a PLL charge pump 52 used in a PLL circuit is configured to produce positive and negative current pulses into the input terminal of the loop filter 30 of the PLL 10.

The loop filter 30 is configured to sequentially process the pulsed error signal X6 produced by the PLL charge pump 52 and to provide corresponding first and second VCO control signals to the VCO 20 depending on the transfer function of the loop filter 30. The first and second VCO control signals correspond to the first frequency calibration setting signal X1 and second frequency calibration setting signal X2, respectively.

In the embodiment in Fig. 2, the boost circuit 40 is part of the second path 32 of the loop filter 30.

The feedback loop 53 is connected between the output side of the VCO and the input side of the PFD 51. Preferably, but not necessarily, at least one frequency divider 56 is arranged within the feedback loop 53. The frequency divider 56 has a divider factor which is preferably tunable or adjustable. However, it may also be possible that additionally or instead a frequency divider 56 with a fixed divider factor is used. The feedback loop 53 is configured to divide the phase of the VCO output clock signal CLK_OUT provided by the VCO 20 by the factor of the frequency divider 56 and to provide a PLL feedback phase signal CLK_PLL to a feedback input terminal of the PFD 51. In a locked condition of the PLL 10, the phase of the CLK output signal CLK_OUT of the VCO 20 follows the reference phase of the input clock signal CLK_IN.

The output terminal 54 is connected to the output side of the VCO 20 and provides the preferably locked PLL output clock signal CLK_OUT.

The PLL 10 according to the present invention also provides a suitable error detection circuit 55. The error detection circuit 55 is connected with the control terminal 41 of the boost circuit 40. The error detection circuit 55 is configured to detect an error condition of the PLL 10 and in case of a detected error, a predetermined control signal X3 is generated and forwarded to the control terminal 41 of the boost circuit 40. A predetermined error condition which may be selectable or definable by the user of the PLL 10, can be a deviation, variation, change, etc. of the frequency of the reference or input clock signal CLK_IN received via the input terminal 50. Alternatively or additionally, the predetermined error condition may be a predetermined deviation, variation, change, etc. of the settings of the frequency divider 56 of the PLL 10.

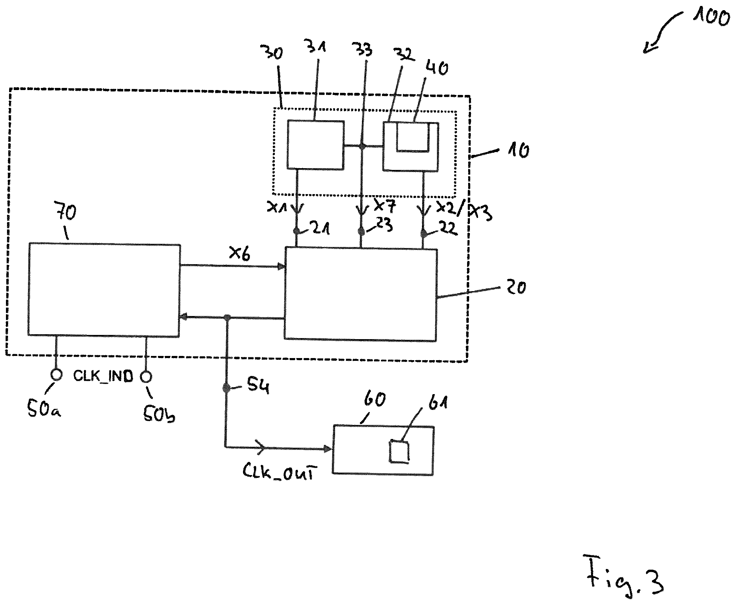

Fig. 3 shows a block diagram of an embodiment of the electronic circuit arrangement according to the invention.

The electronic circuit arrangement in Fig. 3 is denoted by reference symbol 100. The electronic circuit arrangement 100 comprises the PLL circuit 10 and a direct digital synthesizer (DDS) circuit 60.

The circuit design and function of the PLL 10 can correspond to that shown in Fig. 1. and 2. The PLL 10 comprises the VCO 20, the loop filter 30 with the boost circuit 40 integrated within the second filter path 32 and an error generation circuit 70. The error generation circuit 70 basically comprises the PFD 51, the PLL charge pump 52, the feedback loop 53 and optionally the error detection circuit 55.

The VCO 20 together with the elements of the error generation circuit 70 can be integrated in a single chip. The loop filter 30 and/or the boost circuit 40 are preferably implemented within an external filter separate to this single chip. In Fig. 3 this is indicated by the dotted lines.

Preferably, but not compulsory, the output of the error generation circuit 70 and the first input terminal 21 of the VCO 20 are connected together internally in the chip (not shown in Fig. 3) .

The DDS circuit 60 is connected to the output terminal 54 of the PLL circuit 10 which in this embodiment also forms the output terminal of the VCO 20. This output terminal 54 provides the VCO output clock signal CLK_OUT to the DDS circuit 60. The DDS circuit typically comprises a digital to analogue converter (DAC) 61 that is configured to convert the suitably sampled digital waveform of the VCO output clock signal CLK_OUT to an analogue waveform.

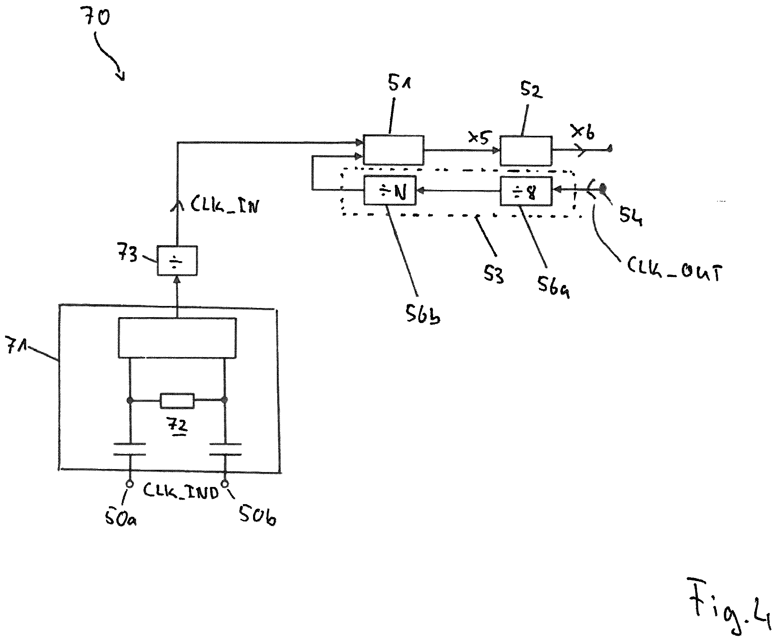

Fig. 4 shows an example of the error generation circuit 70 of Fig. 3 in more detail.

The error generation circuit 70 comprises the PFD 51, the PLL charge pump 52, the feedback loop 53 and an input clock generation circuit 71.

The feedback loop 53 comprises a first and second frequency divider 56a, 56b. In this example, the divider factor of the first frequency divider 56a is fixed and the divider factor of the second frequency divider 56b is tunable or configurable.

The input clock generation circuit 71 is connected with differential input terminals 50a, 50b of the PLL 10 for receiving a differential input clock signal CLK_IND. The differential clock signals CLK_IND are combined to a single clock signal CLK_IN in a filter stage 72 and divided down to a reference clock signal via an tunable divider stage 73. This reference clock signal CLK_IN may then be supplied to the PFD 51.

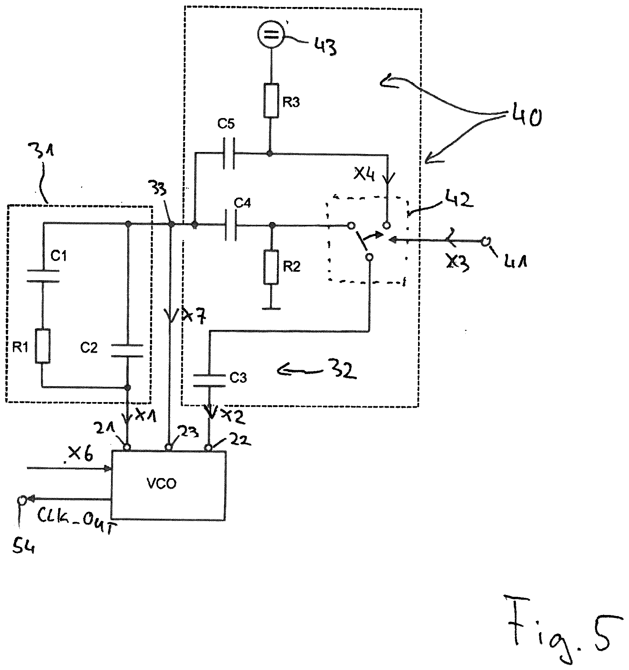

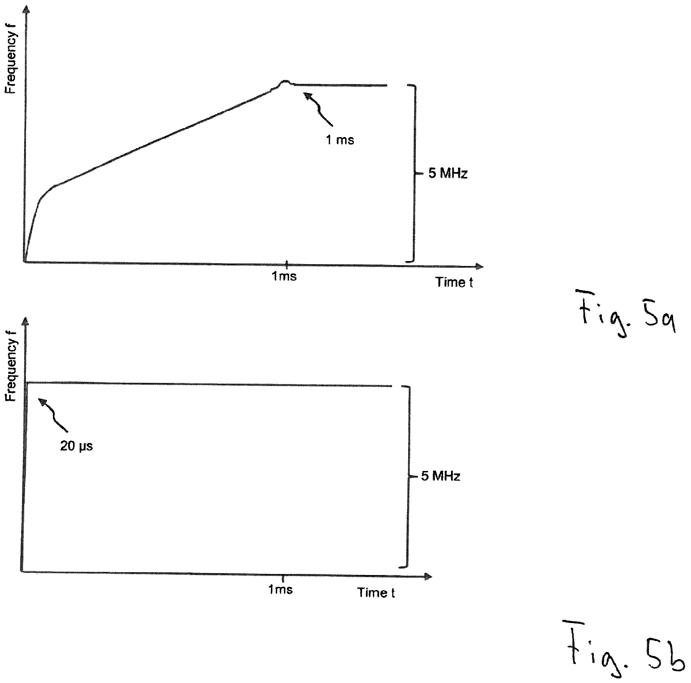

Fig. 5 shows a first embodiment of the loop filter 30 and of the boost circuit 40 according to the invention which may be used in a PLL 10 as shown in one of the examples in Fig. 1 - 3.

In Fig. 5, the loop filter 30 is a standard passive filter. The user can customize the filter elements according to the frequency of the PFD 51, phase of the reference clock noise and DAC output phase noise requirements.

The first filter path 31 is used as a fine filter. The first filter path 31 is connected to the first input terminal 21 of the VCO 20 and the second filter path 32 is a coarse filter and connected to the second input terminal 22 of the VCO 20. The first filter path 31 has a high loop bandwidth to decrease phase noise. The first filter path 31 is further connected via a common tap 33 to the second filter path 32.

The first filter path 31 has a parallel circuit of a capacitor C2 and a series circuit of capacitor C1 and resistor R1. This parallel circuit is arranged between the tap 33 and the first input terminal 21 of the VCO 20. The output signal X1 of the first filter path 31 which has not the full tuning capability of the VCO 20 is provided to the first input terminal 21 of the VCO 20.

The tap 33 between the first filter path 31 and the second filter path 32 is connected with a third input terminal 23 of the VCO 20.

The second filter path 32 comprises a capacitor C3 which is comparably slow. The second filter path 32 is coupled between the tap 33 and the second input terminal 22 of the VCO 20. With the output signal X2 of the second filter path 32 the full tuning capability is provided to the second input terminal 22 of the VCO 20.

The boost circuit 40 which is integrated within the second filter path 32 comprises a controllable switching element 42 and a voltage source 43. On its control side, the switching element 42 is coupled to the control terminal 41 for receiving the predetermined control signal X3 from the error detection circuit 55.

The controllable switching element 42 may be any kind of hardware switch or integrated switch, such as a MOSFET. Preferably, the switching element 42 is a single pole, double throw (SPDT) switch. This switching element 42 is configured to activate the boost circuit 40 and add an additional voltage or boost voltage X4 to the output of the second filter path as soon as a frequency shift of the reference frequency of the input clock signal CLK_IN takes place. The switching time of the switching element 42 is typically in the order of several 10 nsec.

In a normal operating mode, the capacitor C3 of the second filter path 32 is connected via a low pass filter composed of capacitor C4 and resistor R2 directly with the tap 33. The resistor R2 of this RC circuit is preferably grounded or coupled with a predetermined reference voltage. The RC circuit composed of capacitor C4 and resistor R2 is used for temperature stability purposes.

In a normal operating mode, the capacitor C3 of the second filter path 32 is connected via a RC circuit composed of capacitor C4 and resistor R2 with the tap 33. In boost operating mode, when the predetermined control signal X3 is present at the control terminal 41, the switching element 42 is switched and thus activating the boost circuit 40. In this boost operating mode, the capacitor C3 of the second filter is connected to the tap 33 via a further low pass filter composed of capacitor C5 and resistor R3. The resistor R3 of this RC low pass circuit is connected to the voltage source 43. This voltage source 43 which is connected with a positive supply voltage is additionally charging the capacitor C3 of the second filter path 32 with a boost voltage X4. The voltage jump by adding the additional boost voltage X4 matches the difference in the control voltage X2 for the VCO 20.

In boost operating mode, the additional boost voltage X4 is added to the output signal X2 of the second filter path 32.

Without such the additional boost voltage X4, the frequency at the output of the VCO 20 changes only slowly. This can be seen in Fig. 5A which shows the behaviour of the PLL without the additional boost circuit 40. As can be seen, it takes about 1 msec until the frequency change at the output 54 of the VCO 20 is fully accomplished.

By employing the boost circuit 40 and adding a boost voltage X4 to the second input terminal 21 of the VCO 20, the frequency at the output terminal 54 changes much faster as can be seen in Fig. 5B. As can be further seen in Fig. 5B, it takes only about 20 µsec until the frequency change at the output 54 of the VCO 20 is fully accomplished so that the frequency is locked about a factor 50 faster than without employing the boost operating mode and the boost circuit 40.

The RC circuits with capacitor C4 and resistor R2 and with capacitor C5 and resistor R3, respectively, are used mainly for temperature compensation purposes. Typically, but not necessarily, the capacitor values of capacitors C4 and C5 correspond to each other. In the same way, the resistor values of resistors R2 and R3 should also correspond to each other. Typically, the capacitor values of capacitors C4 and C5 are greater than the one of capacitor C3 of the second filter path 32.

Capacitors C4 and C5 guarantee that the voltage jump is relative to the third VCO control signal X7 provided to the third VCO terminal and thereby improving phase noise performance and temperature tracking. The capacitors C4 and C5 should be larger than C3.

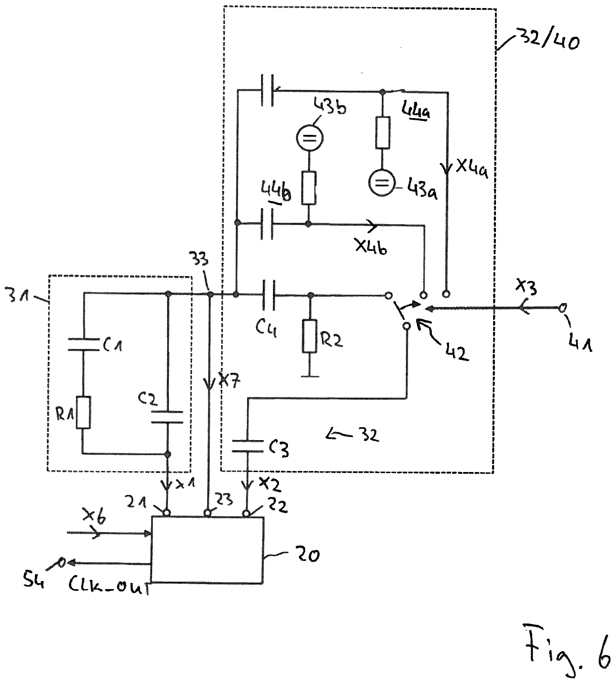

Fig. 6 shows a second embodiment of the loop filter 30 and boost circuit 40 according to the invention.

The boost circuit 40 is composed of several boost paths, wherein in the embodiment shown in Fig. 6 two boost paths 44a, 44b are used. However, depending on the needs, the boost circuit 40 may also comprise more than two boost paths 44a, 44b. Each of the boost paths 44a, 44b comprises an RC circuit composed of a capacitor and resistor and a separate boost voltages 43a, 43b each of them coupled to the resistor of the corresponding RC circuit.

The switching circuit 42 is configured to switch between a normal operating mode and a first boost operating mode for the first boost path 44a and a second boost operating mode for the second boost path 44b. The second boost voltage 43b may be higher than the first boost voltage 43a which allows for higher error compensation. The first boost path 44a provides a first boost voltage X4a and the second boost path 44b provides a second boost voltage X4b.

However, by using a DAC, the second boost operating mode comprises the possibility that the DAC outputs a higher voltage (= second additional voltage).

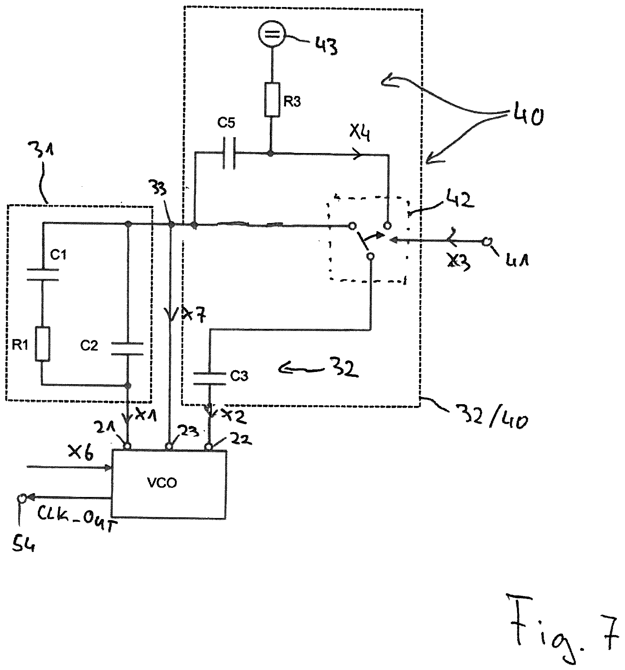

Fig. 7 shows a third embodiment of the loop filter 30 and of the boost circuit 40 according to the invention. Unlike the embodiment shown in Fig. 5, in this example the RC circuit with capacitor C4 and resistor R2 for the second filter path 32 are removed.

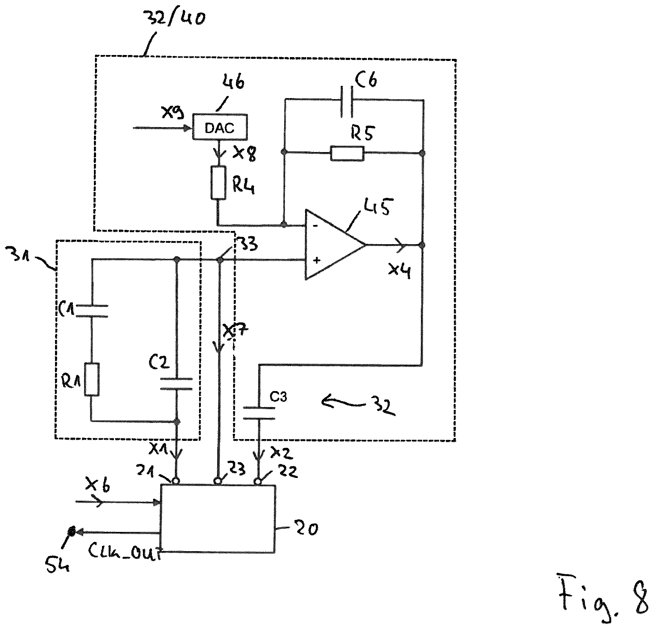

Fig. 8 shows a forth embodiment of the loop filter 30 and of the boost circuit 40 according to the invention.

In contrast to the embodiment shown in Fig. 7, the boost voltage is produced in Fig. 8 by an operational amplifier 45 which is powered (via a resistor R4) by a DAC 46. The output signal X8 of the DAC 46 may be controlled by a suitable digital DAC input signal X9. A variation in the output signal X8 of the DAC 46 which is provided to the positive input terminal of the operational amplifier 45 results in a variation of the boost voltage applied to the capacitor C3 of the second filter path 32 and thus to the second port 22 of the VCO 20.

A parallel connection of a resistor R5 and an optional capacitor C6 is connected between the negative input and the output side of the operational amplifier 45.

This embodiment avoids the use of a specifically provided switching circuit 42. By using an operational amplifier 45 triggered by a DAC 46, however, the noise may be increased so that a suitable noise cancellation circuit would be recommendable in this scenario.

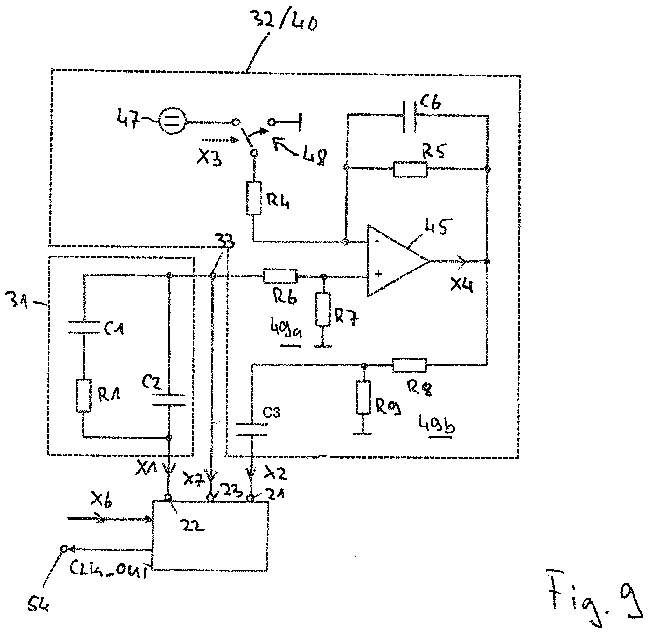

Fig. 9 shows a fifth embodiment of the loop filter 30 and of the boost circuit 40 according to the invention.

In contrast to the embodiment shown in Fig. 8, the DAC 46 for triggering the operational amplifier 45 is replaced in Fig. 9 by a voltage source 47 and a switch 48. Of course, also a current source could be used instead of the voltage source 47. Furthermore, voltage dividers 49a, 49b composed of suitably dimensioned resistors R6/R7 and R8/R9 are used before and/or after the operational amplifier 45 in order to reduce any occurring additional noise and/or compensate for the gain of the operational amplifier 45.

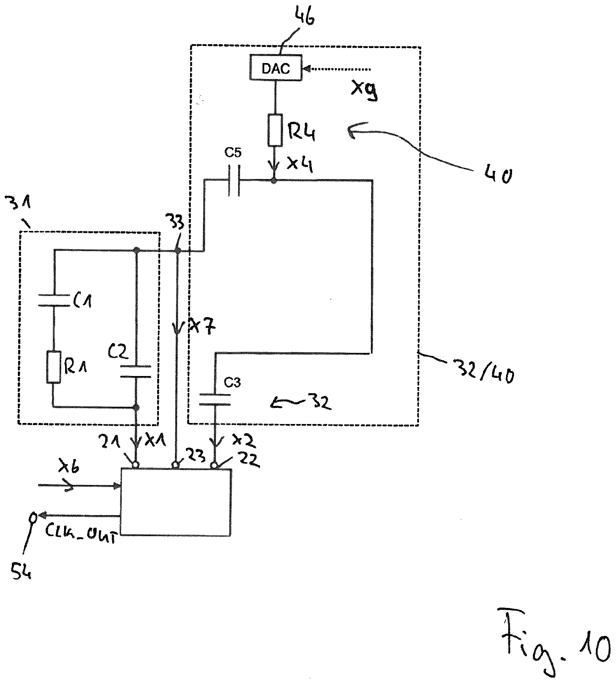

Fig. 10 shows a sixth embodiment of the loop filter 30 and of the boost circuit 40 according to the invention.

Instead of the operational amplifier 45 shown in Fig. 8, a DAC 46 triggered by DAC input signal X9 is used. The DAC 46 is AC coupled to the second port 22 of the VCO 20 (via resistor R4 and capacitor C3) and to the third port 23 of the VCO 20 (via resistor R4 and capacitor C5). The boost circuit 40 comprising the DAC 46 is configured such that if the change in frequency of the input clock signal CLK_IN exceeds a predetermined threshold, then the DAC 46 adds a boost voltage X4 to the second and third terminals 22, 23. Otherwise, no boost voltage is added.

In the foregoing specification, the invention has been described with reference to specific examples of embodiments of the invention. It will, however, be evident that various modifications and changes may be made therein without departing from the broader spirit and scope of the invention as set forth in the appended claims. For example, the connections between various circuit elements as shown and described with respect to the drawings may be a type of connection suitable to transfer signals from or to the respective nodes, units, devices or circuit elements, for example via intermediate devices. Accordingly, unless implied or stated otherwise, the connections may for example be direct connections or indirect connections.

Because the apparatuses implementing the present invention are, for the most part, composed of electronic components and circuits known to those skilled in the art, details of the circuitry and its components will not be explained in any greater extent than that considered necessary as illustrated above, for the understanding and appreciation of the underlying concepts of the present invention and in order not to obfuscate or distract from the teachings of the present invention.

The devices may be physically distributed over a number of apparatuses, while functionally operating as a single device. Devices functionally forming separate devices may be integrated in a single physical device. Those skilled in the art will recognize that the boundaries between logic or functional blocks are merely illustrative and that alternative embodiments may merge logic or functional blocks or impose an alternate decomposition of functionality upon various logic or functional blocks.

In the description, any reference signs shall not be construed as limiting the claim. The word "comprising" does not exclude the presence of other elements or steps then those listed in a claim. Furthermore, the terms "a" or "an", as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles. Unless stated otherwise, terms such as "first" and "second" are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage. The order of method steps as presented in a claim does not prejudice the order in which the steps may actually be carried out, unless specifically recited in the claim.

Skilled artisans will appreciate that the illustrations of chosen elements in the drawings are only used to help to improve the understanding of the functionality and the arrangements of these elements in various embodiments of the present invention.

Also, common and well understood elements that are useful or necessary in a commercially feasible embodiment are generally not depicted in the drawings in order to facilitate the understanding of the technical concept of these various embodiments of the present invention. It will further be appreciated that certain procedural stages in the described methods may be described or depicted in a particular order of occurrence while those skilled in the art will understand that such specificity with respect to sequence is not actually required.

### LIST OF USED REFERENCE SIGNS

- 10: phase locked loop, PLL circuit, PLL

- 20: variable frequency oscillator, voltage controlled oscillator, VCO
- 21: first input terminal (of the VCO)
- 22: second input terminal (of the VCO)
- 23: third input terminal (of the VCO)

- 30: loop filter
- 31: first filter path
- 32: second filter path
- 33: tap

- 40: boost circuit
- 41: control terminal
- 42: controllable switching element, switching circuit
- 43, 43a, 43b: boost voltage, voltage source
- 44a, 44b: boost paths
- 45: operational amplifier
- 46: DAC
- 47: boost voltage, voltage source
- 48: switch
- 49a, 49b: voltage dividers

- 50: input terminal
- 50a, 50b: differential input terminals
- 51: phase detector, phase comparator, phase frequency detector, PFD
- 52: PLL charge pump
- 53: feedback loop
- 54: output terminal
- 55: error detection circuit
- 56, 56a, 56b: frequency dividers

- 60: direct digital synthesizer circuit, DDS
- 61: digital to analog converter, DAC

- 70: error generation circuit
- 71: input clock generation circuit
- 72: filter stage
- 73: tunable divider stage

- 100: electronic circuit arrangement

- C1 - C5: capacitors
- R1 - R9: resistors

- CLK_IN: input clock signal
- CLK_IND: differential input clock signal
- CLK_PLL: PLL feedback clock signal
- CLK_OUT: VCO output clock signal

- X1: output signal of the first filter path, first frequency calibration setting signal, first VCO control signal
- X2: output signal of the second filter path, second frequency calibration setting signal, second VCO control signal
- X3: control signal
- X4, X4a, X4b: additional voltage signal, boost voltage
- X5: phase error signal
- X6: pulsed error signal
- +X7: output signal, third frequency calibration setting signal, third VCO control signal
- X8: output signal
- X9: DAC input signal

## Claims

1. A phase-locked loop (PLL) circuit (10), the PLL circuit (10) comprising:
a variable frequency oscillator (20) comprising at least one first input terminal (21) and at least one second input terminal (22),
a loop filter (30) configured to control operation of the variable frequency oscillator (20),
wherein the loop filter (30) comprises a first filter path (31) connected to the first input terminal (21) of the variable frequency oscillator (20) and a second filter path (32) connected to the second input terminal (22) of the variable frequency oscillator (20),
wherein the first filter path (31) has a higher bandwidth and a smaller tuning range than the second filter path (32),
a controllable boost circuit (40) coupled to or part of the second filter path (32) and comprising a control terminal (41), wherein the boost circuit (40) is configured to provide at least one additional voltage signal (X4) to the second input (22) terminal in case the control terminal (41) receives a predetermined control signal (X3).

2. The PLL circuit according to claim 1, further comprising: an error detection circuit (55) connected to the boost circuit (40) and configured to detect an error condition of the PLL circuit (10), wherein the error detection circuit (55) is configured to provide the predetermined control signal (X3) to the control terminal (41) of the boost circuit (40) in case an error condition of the PLL circuit (10) is detected, wherein an error condition is in particular at least one of:
- a predetermined variation or change of the external reference frequency;
- a predetermined variation or change of the settings of the divider of the PLL circuit;
- exceeding a predetermined settling time.

3. The PLL circuit according to any of the preceding claims, wherein the variable frequency oscillator (20) is a voltage controlled oscillator (20).

4. The PLL circuit according to any of the preceding claims, wherein the boost circuit (40) is an integral part of the second filter path (32).

5. The PLL circuit according to any of the preceding claims, wherein the loop filter (30) is an external filter circuit separate from the integrated circuit elements of the remaining PLL circuit (10).

6. The PLL circuit according to any of the preceding claims, wherein the first filter path (31) is faster than the second filter path (32).

7. The PLL circuit according to any of the preceding claims, wherein the boost circuit (40) comprises a switching circuit (42) which is configured to switch the loop filter (30) and in particular its second filter path (32) between a normal operating mode and at least one boost operating mode.

8. The PLL circuit according to any of the preceding claims, wherein the boost circuit (40) comprises at least one voltage source (43; 43a, 43b; 45, 46, 47) which is configured to provide the additional voltage signal (X4, X4a, X4b) to the second filter path (32) and/or to the second input terminal (22) in case the boost circuit (40) is activated , wherein at least one of the voltage sources (43; 43a, 43b; 45, 46, 47) is in particular realised by a voltage divider, an operational amplifier (45), a DAC (46) and/or a reference diode.

9. The PLL circuit according to any of the preceding claims, wherein the boost circuit (40) comprises at least two different boost paths (44a, 44b), each of them providing a different additional voltage signal (X4a, X4b) to the second input terminal (22) .

10. The PLL circuit according to any of the preceding claims, wherein the second filter path (32) comprises a first capacitor (C3) arranged between a switching circuit (42) and the second input terminal (22).

11. The PLL circuit according to any of the preceding claims, wherein at least one of the boost paths (44a, 44b) and/or the second filter path (32) comprises an RC circuit, and/or wherein the variable frequency oscillator (20) comprises a third input terminal (23), wherein a tap (33) between the first filter path (31) and the second filter path (32) is directly connected to the third input terminal (23).

12. The PLL circuit according to any of the preceding claims, further comprising at least one frequency divider (56, 56a, 56b) and a phase frequency detector (PFD) (51), wherein the loop filter (30) is configured to sequentially process a phase error signal (X5, X6) provided by the PFD (51) or a PLL charge pump (52) and to provide corresponding control signals (X1, X2) to the variable frequency oscillator (20), in particular further comprising a PLL charge pump (52) arranged between the PFD (51) and the loop filter (30).

13. An electronic circuit arrangement (100), the electronic circuit arrangement (100) comprising:
a PLL circuit (10) according to any of the preceding claims;
a direct digital synthesizer (DDS) circuit (60) connected to an output (54) of the PLL circuit (10).

14. The electronic circuit arrangement of claim 13, wherein the DDS circuit (60) comprises a high frequency digital to analogue circuit (DAC).

15. An electronic apparatus, comprising the electronic circuit arrangement (100) according to any of the claims 13 or 14, wherein the electronic apparatus preferably comprises at least one of:
a network analyzer;
a signal analyzer;
a spectrum analyzer;
a signal generator;
a measurement apparatus;
signal source.
